# EUROPEAN PATENT APPLICATION

(11) **EP 3 670 696 A1**
(43) Date of publication of application: **24.06.2020**
(21) Application number: 18215460.9
(22) Date of filing: 21.12.2018
(51) Int. Cl.: C23C 14/02, C23C 14/06, C23C 14/32, C23C 16/26, C23C 28/04, C23C 28/00

(54) **CORROSION RESISTANT CARBON COATINGS**

(71) Applicant: Nanofilm Technologies International Pte Ltd, Singapore 139959 (SG)
(72) Inventor: The designation of the inventor has not yet been filed
(74) Representative: Schlich, George

(57) **Abstract**

The invention provides substrates with a multi-layer coating, comprising in order:
i) the substrate;
ii) a seed layer;
iii) a barrier layer deposited via a CVD method; and
iv) a functional layer deposited via a PVD method,
and methods of making such coatings. The coatings of the invention have been shown to possess good resistance to corrosion.

## Description

### Introduction

This present invention relates to improved corrosion resistant carbon coatings and methods for producing such coatings.

### Background to the Invention

A large variety of deposition techniques are used to coat substrates. Vapor deposition technology is typically used to form thin film deposition layers in various types of applications, including microelectronic applications and heavy-duty applications. Such deposition technology can be classified in two main categories. A first category of such deposition technology is known as Chemical Vapor Deposition (CVD). CVD generally refers to deposition processes occurring due to a chemical reaction. Common examples of CVD processes include semiconducting Si layer deposition, epitaxy and thermal oxidation.

A second category of deposition is commonly known as Physical Vapor Deposition (PVD). PVD generally refers to the deposition of solid substances occurring as a result of a physical process. The main concept underlying the PVD processes is that the deposited material is physically transferred onto the substrate surface via direct mass transfer. Typically, no chemical reaction takes place during the process and the thickness of the deposited layer is independent of chemical reaction kinetics as opposed to CVD processes.

Sputtering is a known physical vapor deposition technique for depositing compounds on a substrate, wherein atoms, ions or molecules are ejected from a target material (also called the sputter target) by particle bombardment so that the ejected atoms or molecules accumulate on a substrate surface as a thin film.

Another known physical vapor deposition technique is cathodic vapor arc (CVA) deposition methods. In this method, an electric arc is used to vaporize material from a cathode target. Consequently, the resulting vaporized material condenses on a substrate to form a thin film of coating.

Amorphous carbon is a free, reactive form of carbon which does not have a crystalline form. Various forms of amorphous carbon films exist and these are usually categorised by the hydrogen content of the film and the sp²:sp³ ratio of the carbon atoms in the film.

In an example of the literature in this field, amorphous carbon films are categorised into 7 categories (see table below taken from "Name Index of Carbon Coatings" from Fraunhofer Institut Schich- und Oberflächentechnik):

| **Amorphous Carbon Films** | | | | | | |
|---|---|---|---|---|---|---|
| Hydrogen-Free | | | Hydrogenated | | | |
| Unmodified | | Modified | Unmodified | | Modified with | |
| | | With metals | | | Metals | Non-metals |
| sp² | sp³ | sp² | sp² or sp³ | sp³ | sp² | sp² |
| Hydrogen-free amorphous carbon | Tetrahedral, hydrogen-free amorphous carbon | Metal-containing, hydrogen-free amorphous carbon | Hydrogenate d amorphous carbon | Tetrahedral, hydrogenate d amorphous carbon | Metal-containing, hydrogenated amorphous carbon | Non-metal containing hydrogenate d amorphous carbon |
| **a-C** | **ta-C** | **a-C:Me** | **a-C:H** | **ta-C:H** | **a-C:H:Me** | **a-C:H:X** |

Tetrahedral hydrogen-free amorphous carbon (ta-C) is characterised in that it contains little or no hydrogen (less than 5%mol, typically less than 2%mol) and a high content of sp³ hybridised carbon atoms (typically greater than 80% of the carbon atoms being in the sp³ state).

Whilst the term "diamond-like carbon" (DLC) is sometimes used to refer to all forms of amorphous carbon materials, the term as used herein refers to amorphous carbon materials other than ta-C. Common methods of DLC manufacture use hydrocarbons (such as acetylene), hence introducing hydrogen into the films (in contrast to ta-C films in which the raw material is typically hydrogen free high purity graphite).

In other words, DLC typically has an sp² carbon content of greater than 50% and/or a hydrogen content of 20%mol and above. The DLC may be undoped or doped with metals or non-metals (see table above).

Tetrahedral amorphous carbon coatings have high hardness and low friction coefficient, and are excellent wear-resistant coatings. At the same time, the ta-C can maintain its stability over long time periods in harsh environments (such as acidic or alkaline conditions) and therefore has broad prospects in the development of anti-corrosion applications. However, due to small defects in the PVD processes, complete coverage of substrate is not achieved and small "pin-holes" in the ta-C film make the underlying substrate susceptible to corrosion. This might happen because e.g. of the presence of large (relatively speaking) dust particles in the very thin coatings. Pin holes can be reduced in a clean room but not absolutely avoided.

In many applications, parts are required to have both the strength of steel and long-term use in harsh environments (such as acid, alkali or seawater) while maintaining their friction and wear properties. It is known for manufacturers of smartphones to test devices by immersion in swimming pool water for up to a week. This is a tough test and known coatings fail this test at too high a rate. Separately, coatings on electrodes require virtual absence of pin holes for corrosion free operation; few coatings meet this criterion.

At present, whilst certain types of stainless steel (such as 316L) possess good corrosion resistance, the hardness of this material is low and it therefore cannot be used for high-strength structural parts. Meanwhile, high-strength structural steels (such as 40Cr) are generally prone to rust.

Conventional surface treatment processes (nitriding, carburizing, etc.) confer limited corrosion resistance on steel. Moreover, due to problems such as the temperature of the process, such processes cannot be used in the field of precision parts (as they result in problems such as brittle fracture, size, etc). In addition, for certain coatings an electrochemical reaction (referred to as the "small battery effect") occurs between the coating and the substrate which causes corrosion of the coating and/or substrate. Lastly, some PVD-deposited coatings are simply not very corrosion resistant.

WO 2009/151404 discloses applying coatings using CVA methods followed by a thick CVD layer. Corrosion resistance of the coatings is not addressed.

WO 2009/151404 discloses applying coatings using CVA and PVD (but not CVA) where the thickness of the CVA layer is greater than the thickness of the PVD (non CVA) layer. Again, corrosion resistance of the coatings is not addressed.

There therefore exists the need for thin, corrosion resistant carbon coatings.

An object of the present invention is to provide coatings that are an alternative to and preferably offer improvements in relation to corrosion resistance, addressing one or more problems identified in the art.

### The Invention

The inventor of the present application has found that carbon coatings with one or more alternating layers of a first material (e.g. DLC) deposited by CVD and a second material (e.g. TAC) deposited by FCVA have good hardness and wear resistance as well as being more resistant to corrosion compared to films formed by CVA-deposition alone. More generally, it is found that a layer deposited via CVD as a component of a coating comprising PVD-deposited layers provides a coating with corrosion resistance.

Accordingly, the present invention provides a substrate with a multi-layer coating, comprising in order:
i) the substrate;
ii) a seed layer;
iii) a barrier layer deposited via a CVD method; and
iv) a functional layer deposited via a PVD method.

Suitably, and as illustrated in examples, the present invention provides a substrate with a multi-layer coating, comprising in order:
i) the substrate;
ii) a seed layer;
iii) a barrier layer comprising DLC deposited via a CVD method; and
iv) a functional layer comprising TAC.

Similarly provided is a coating for a substrate, comprising in order:
i) a seed layer;
ii) a barrier layer deposited via a CVD method; and
iii) a functional layer deposited via a PVD method.

Suitably, the coating may comprise
i) a seed layer;
ii) a barrier layer comprising DLC deposited via a CVD method; and
iii) a functional layer comprising TAC.

Also provided is a method of coating a substrate, comprising
i) providing a substrate;
ii) depositing onto the substrate a seed layer;
iii) depositing onto the substrate a layer via a CVD method; and
iv) depositing onto the substrate of a layer via a PVD method.

The coatings of the invention may comprise multiple alternating layers of CVD-deposited layers and PVD-deposited layers (i.e. alternating barrier layers and functional layers). The CVD-deposited layer acts as a barrier layer to protect the underlying substrate from corrosion.

Thus, the invention enables coating of a substrate with a coating that shows good hardness and wear resistance as well as good corrosion resistance, as illustrated by the testing of embodiments of the invention described in more detail below.

### Detailed Description of the Invention

As discussed above, the term "tetrahedral amorphous carbon" (ta-C or TAC) as used herein refers to amorphous carbon having a low hydrogen content and a low sp² carbon content.

Ta-C is a dense amorphous material described as composed of disordered sp³, interlinked by strong bonds, similar to those that exist in disordered diamond (see Neuville S, "New application perspective for tetrahedral amorphous carbon coatings", QScience Connect 2014:8, http://dx.doi.org/10.5339/connect.2014.8). Due to its structural similarity with diamond, ta-C also is a very hard material with hardness values often greater than 30 GPa.

For example, the ta-C may have a hydrogen content less than 10%, typically 5% or less, preferably 2% or less (for example 1% or less). The percentage content of hydrogen provided here refers to the molar percentage (rather than the percentage of hydrogen by mass). The ta-C may have an sp² carbon content less than 30%, typically 20% or less, preferably 15% or less. Preferably, the ta-C may have a hydrogen content of 2% or less and an sp² carbon content of 15% or less. The ta-C is preferably not doped with other materials (either metals or non-metals).

By contrast, the term "diamond-like carbon" (DLC) as used herein refers to amorphous carbon other than ta-C. Accordingly, DLC has a greater hydrogen content and a greater sp² carbon content than ta-C. For example, the DLC may have a hydrogen content of 20% or greater, typically 25% or greater, for example 30% or greater. The percentage content of hydrogen provided here again refers to the molar percentage (rather than the percentage of hydrogen by mass). The DLC may have an sp² carbon content of 50% or greater, typically 60% or greater. Typically, the DLC may have a hydrogen content of greater than 20% and an sp² carbon content of greater than 50%. The DLC may be undoped or doped with metals and/or non-metals.

The invention advantageously provides deposited coatings via PVD methods, for example ta-C coatings deposited via FCVA, that are hard and have high wear resistance, and now good corrosion resistance as a consequence of the one or more intermediate CVD-deposited layer(s).

Accordingly, the present invention provides a substrate with a multi-layer coating, comprising in order:
i) the substrate;
ii) a seed layer;
iii) a barrier layer deposited via a CVD method; and
iv) a functional layer deposited via a PVD method.

Choice of the substrate material is broad, and many substrates made of a wide range of materials can be coated. The substrate is usually metallic and generally is or comprises a metal or an alloy. Steels are suitable substrates, e.g. steel, stainless steel, HSS, tool steel and alloy steel. Ti or its alloys, Al or its alloys, ceramics such as Al₂O₃, ZrO₂, Si₃N₄, SiC, and plastics such as PEEK, POM, LCP, ABS, PC are also suitable substrates. Articles are generally made of the substrate and then have a coating of the invention applied / deposited.

The functional layer (deposited via a PVD method) preferably comprises or consists of TAC. Typically, the uppermost layer of the coating (i.e. the layer furthest away from the substrate) is a layer comprising TAC in order to impart the hardness of the TAC on the final coating. Preferably, the functional layers comprising TAC consist of TAC.

The thickness of each of the functional layers is typically from 0.1µm to 3µm, for example from 0.2µm to 2µm, preferably from 0.5µm to 1µm. The functional layers (e.g. those comprising TAC) are preferably deposited via FCVA.

The barrier layers typically comprise or consist of DLC and are located between the seed layer and the PVD-deposited (e.g. TAC-containing) layers and optionally also between adjacent PVD-deposited (e.g. TAC-containing) layers. The barrier layers preferably consist of DLC. The barrier layers are deposited via a chemical vapour deposition technique. Examples of such techniques include plasma enhanced-CVD and hot filament-CVD. Such techniques are well known to those skilled in the art.

It has been found that deposition via CVD results in fewer gaps in the produced coating and this layer grows on top of the substrate avoiding pin holes. CVD provides good coverage of the material being coated and therefore acts as a barrier to corrosion causing substances (e.g. acids). Pin holes in the PVD-deposited layer can be plugged with the CVD-deposited layer.

When the barrier layer comprises or consists of DLC, the DLC is typically not conductive unless doped. An option, therefore, is for the DLC to be metal-doped in order to increase the electric conductivity of the coating. This depends upon the end-use of the coating.

When the coating comprises a single barrier layer, the thickness of the barrier layer may be from 0.05µm from to 0.5µm, for example from 0.07µm to 0.4µm, preferably from 0.1µm to 0.3µm.

Alternatively, when the coating comprises multiple barrier layers, the thickness of each barrier layer may be 20nm or less, 10nm or less, for example 5nm or less and preferably 3nm or less.

Accordingly, the total thickness of all barrier layers within the coating may be from 0.05µm from to 0.5µm, for example from 0.07µm to 0.4µm, preferably from 0.1µm to 0.3µm.

Barrier layers of this thickness are thick enough to confer sufficient corrosion resistance on the layered coating, but without significantly impacting the overall hardness and/or wear-resistance and/or conductivity of the coatings, these properties being imparted to the coatings by the other, e.g. functional layers. Hence, pin holes in the relatively thicker, functional PVD-deposited layer can be plugged with the relatively thin CVD-deposited layer without adversely impacting upon the properties of the functional layer.

A seed layer is included to promote adhesion of the barrier layer to the underlying substrate. The nature of the seed layer will therefore depend on the nature of the substrate. When the substrate is metallic, the seed layer preferably comprises Cr, W, Ti, NiCr, Si or mixtures thereof. When the substrate is a steel substrate, an example of a preferred material for the seed layer is NiCr. The thickness of the seed layer is typically from 0.05µm to 2µm, for example from 0.1µm to 1µm, preferably from 0.2µm to 0.5µm.

The overall thickness of the coating (including the seed layer and all barrier layers and TAC-containing layers present) is typically 5µm or less, for example 3µm or less, preferably 2µm or less.

An aim of the invention is to provide hard coatings, for many applications. Coated substrates of the invention preferably have a coating with a hardness of at least 1000 HV, more preferably 1500 HV or more, or 2000 HV or more. Coatings with a wide range of measured hardness values within these ranges have been made (see examples below), including coatings with hardness of approximately 2300 HV. For different end applications, according sometimes to user choice, different hardness may be appropriate.

Conventional CVD and PVD methods, specifically CVA and FCVA processes, are known and used for a wide range of substrates and the methods of the invention are similarly suitable for coating a wide range of substrates. Solids, both conducting and non-conducting, are generally suitable and seed layers and adhesion layers can be used to improve coating adhesion and strength, and to render surfaces amenable to being coated. Substrates made of metal, alloy, ceramics and mixtures thereof can be coated. Typically, the substrate is a corrosion-prone substrate, such as steel.

Coatings of the invention can be multilayered and the respective layers may independently be deposited using a range of known and conventional deposition techniques, including CVD, PVD, magnetron sputtering and multi-arc ion plating. Sputtering is one suitable method, especially for the seed layer. PVD is suitably used for the TAC-containing layers, e.g. CVA. The CVA process is typically a filtered cathodic vacuum arc (FCVA) process, e.g. as described below. Apparatus and methods for FCVA coatings are known and can be used as part of the methods of the invention. The FCVA coating apparatus typically comprises a vacuum chamber, an anode, a cathode assembly for generating plasma from a target and a power supply for biasing the substrate to a given voltage. The nature of the FCVA is conventional and not a part of the invention.

CVD processes can make use of ion sources (including end-hall ion sources, Kaufman ion sources, anode layer sources, hot filament ion sources and hollow cathode ion sources) for the material being deposited. Alternatively, the coating material may be provided as a gas which is then charged/ionised using a power supply (e.g. DC power supply, pulsed DC power supply or RF power supply).

An example of a steel substrate with a multi-layer coating comprises in order:
i) the steel substrate;
ii) a seed layer having a thickness from 0.05µm to 2µm;
iii) a barrier layer deposited by a CVD method, the barrier layer comprising DLC and having a thickness of 10nm or less; and
iv) a layer comprising TAC deposited by CVA and having a thickness of from 0.1µm to 3µm.

Hardness is suitably measured using the Vickers hardness test (developed in 1921 by Robert L. Smith and George E. Sandland at Vickers Ltd; see also ASTM E384-17 for standard test), which can be used for all metals and has one of the widest scales among hardness tests. The unit of hardness given by the test is known as the Vickers Pyramid Number (HV) and can be converted into units of pascals (GPa). The hardness number is determined by the load over the surface area of the indentation used in the testing. As examples. Martensite a hard form of steel has HV of around 1000 and diamond can have a HV of around 10,000 HV (around 98 GPa). Hardness of diamond can vary according to precise crystal structure and orientation but hardness of from about 90 to in excess of 100 GPa is common.

The invention advantageously provides high hardness and wear-resistant ta-C-based coatings. Compared to known TAC coatings, the coatings of the invention have improved resistance to corrosion due to the presence of the DLC barrier layer(s).

### Brief Description of the Drawings

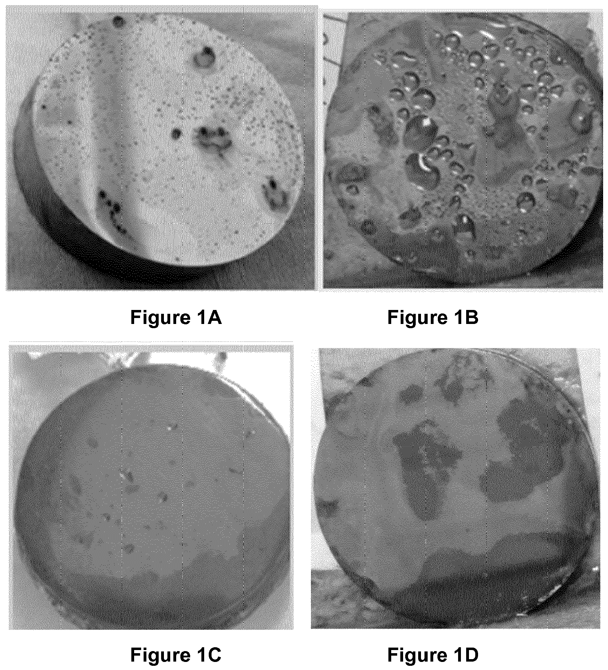

Fig. 1A shows an uncoated steel substrate (comparative example) following corrosion testing as described in Example 2.
Fig. 1B shows a TAC-coated steel substrate (comparative example) following corrosion testing as described in Example 2.
Fig. 1C shows a steel substrate coated with a coating of the invention following corrosion testing as described in Example 2.
Fig. 1D shows a DLC-coated steel substrate (comparative example) following corrosion testing as described in Example 2.

### Detailed Description of the Invention

### Example 1

The protocol for making corrosion resistant films according to the invention is provided below:
a. A high speed steel (HSS) substrate is first prepared for coating by ultrasonic cleaning with a detergent. The substrate is then rinsed with deionised water and then dried (in accordance with standard cleaning processes used in the vacuum industry).
b. The cleaned HSS substrate is placed in a vacuum chamber having sputtering, CVD and FCVA targets/sources.
c. The chamber is pumped down to reduce the pressure to less than 1x10⁻⁵ Torr (0.00133 Pa), and heated to between 150°C and 200°C.
d. Ion cleaning is conducted in the chamber in order to activate the surface of the substrate to promote adhesion.
e. Seed layer deposition: Sputtering, 100°C - 150°C, NiCr targets, layer thickness = 1.0µm.
f. Barrier layer deposition: Plasma Assisted CVD, C₂H₂ (flow rate = 100sccm) and Ar (flow rate = 200 sccm), bias voltage = 600V, bias current = 8A, bias duty cycle = 50%; layer thickness = 0.2µm.
g. Functional layer deposition: FCVA, <100°C, solid graphite target, coating thickness = 1.3µm.

Sputtering, CVD and FCVA targets and sources are well-known and commercially available.

### Example 2 - Corrosion Resistance Testing

A salt spray test was used to determine the corrosion resistance of the coatings of the invention (as produced in Example 1) compared to uncoated and DLC coated substrates.

Test materials:
a. Uncoated high speed steel W₆Mo₅Cr₄V₂ substrate (without surface treatment). Hardness = 746.9 HV
b. TAC coated high speed steel W₆Mo₅Cr₄V₂. Coating thickness = 2.3µm. Hardness = 2212 HV. The coating was prepared according to the method of Example 1, with the omission of barrier layer deposition step (f).
c. High speed steel W₆Mo₅Cr₄V₂ coated with TAC coating of the invention (see Example 1). Coating thickness = 2.5µm. Hardness = 2317 HV
d. High speed steel W₆Mo₅Cr₄V₂ substrate coated with DLC only. Coating thickness = 2.5µm. Hardness = 1540 HV.

Salt Spray Conditions:
- Salt solution concentration: (5 ± 1)% NaCl
- pH = 6.5-7.2
- Salt spray settling rate: (1-2mL) / 80cm²;
- Temperature inside the salt spray box: 35±2°C;
- Spray 1 min every 10 minutes;

Results:
a) Uncoated - Obvious rust of the surface after 10 minutes (see Figure 1A)
b) TAC coated - Visible, erasable rust after 18 hours (see Figure 1B). When subjected to a scratch test, the coating showed a critical load of 38.66N.
c) Invention - No obvious rust after 100 hours (see Figure 1C). When subjected to a scratch test, the coating showed a critical load of 30.60N.
d) DLC coated - No obvious rust after 100 hours (see Figure 1D). When subjected to a scratch test, the coating showed a critical load of 20.22N.

As an indication of the wear-resistance of the coatings, a Taber abrasion test was conducted on test materials b), c) and d), with the following conditions:
- Instrument: Taber Linear Abraser TLA 5700
- Abradant: CS-17 Wearaser®
- Test Load: 1 kg weight
- Cycle Speed: 60 cycles/min
- Stroke Length: 15 mm

No visible scratches were seen on either test material b) and c) following 30,000 cycles of the taber test. However, visible scratches were seen on test material d) following only 5,000 cycles of the taber test.

The coatings of the invention therefore show improved corrosion resistance compared to uncoated substrates and substrates coated with DLC alone. The coatings of the invention also have comparable hardness and wear resistance properties to TAC-only coated substrates and have superior hardness and wear resistance properties comparted to DLC-only coated substrates.

## Claims

1. A substrate with a multi-layer coating, comprising in order:
i) the substrate;
ii) a seed layer;
iii) a barrier layer deposited via a CVD method; and
iv) a functional layer deposited via a PVD method.

2. A coated substrate according to claim 1 comprises multiple alternating barrier layers and functional layers.

3. A coated substrate according to claim 2 comprising alternating layers of up to 10 barrier layers and up to 10 functional layers

4. A coated substrate according to any one of claims 1 to 3 wherein the barrier layer comprises DLC.

5. A coated substrate according to any one of claims 1 to 4 wherein the functional layer comprises TAC.

6. A coated substrate according to any of claims 1 to 5 wherein the total thickness of all barrier layers in the substrate is from 0.05µm to 0.5µm.

7. A coated substrate according to any of claims 1 to 6 wherein the thickness of the functional layer is from 0.1µm to 3µm.

8. A coated substrate according to any of claims 1 to 7 wherein the thickness of the seed layer is from 0.05µm to 2µm.

9. A coated substrate according to any of claims 1 to 8 wherein the overall thickness of the coating is less than 5µm.

10. A coated substrate according to any of claims 1 to 9 wherein the functional layer(s) is/are deposited by FCVA.

11. A coated substrate according to any of claims 1 to 10 wherein the seed layer is formed from Cr, W, Ti, NiCr, Si or mixtures thereof.

12. A coated substrate according to any of claims 1 to 11 wherein the substrate is a steel substrate.

13. A steel substrate with a multi-layer coating comprising in order:
i) the steel substrate;
ii) a seed layer having a thickness from 0.05µm to 2µm;
iii) a barrier layer deposited by a CVD method, the barrier layer comprising DLC and having a thickness of 10nm or less; and
iv) a layer comprising TAC deposited by CVA and having a thickness of from 0.1µm to 3µm.

14. A method of coating a substrate, the method comprising
i) providing a substrate;
ii) depositing onto the substrate a seed layer;
iii) depositing onto the substrate a layer via a CVD method; and
iv) depositing onto the substrate a layer via a PVD method.

15. A method of coating a substrate, the method comprising
i) providing a substrate;
ii) depositing onto the substrate a seed layer;
iii) depositing onto the substrate a layer of DLC via a CVD method; and
iv) depositing onto the substrate a layer of TAC via a PVD method.
